# EUROPÄISCHE PATENTSCHRIFT

(11) **EP 1 501 195 B1**
(45) Veröffentlichungstag und Bekanntmachung des Hinweises auf die Patenterteilung: **19.04.2006**
(21) Anmeldenummer: 03016974.2
(22) Anmeldetag: 25.07.2003
(51) Int. Cl.: H03M 3/02, G01R 23/10, G01R 35/00, G06M 3/02, G01R 23/15

(54) **Anordnung zur Generierung eines Taktsignals für einen Sigma-Delta-Analog-Digital-Wandler**
Circuit arrangement to generate a clock signal for a sigma-delta analog-to-digital converter
Dispositif générateur du signal d'horloge pour un convertisseur sigma-delta analogique-numérique

(43) Veröffentlichungstag der Anmeldung: 26.01.2005
(73) Patentinhaber: Siemens Schweiz AG, 8047 Zürich (CH)
(72) Erfinder: Stoll, Walter, 6417 Sattel (CH)
(74) Vertreter: Weise, Wolfgang

(56) Entgegenhaltungen:
- JP-A- 2002 196 024
- US-A- 4 993 052
- US-A- 5 349 352

## Beschreibung

Die Erfindung bezieht sich auf ein Verfahren und eine Einrichtung gemäss den Oberbegriffen der Ansprüche 1 und 4.

Solche Verfahren und Anordnungen eignen sich beim Umsetzen von analogen Signalen in digitale Signale, beispielhaft in einer Einrichtung zur Überwachung, Steuerung und Regelung einer betriebstechnischen Anlage eines Gebäudes.

Die betriebstechnische Anlage ist beispielhaft eine Heizungs-, Lüftungs- und Klimaanlage, mit Zutritts- und Feuerüberwachungseinrichtungen oder allgemein eine Gebäudeautomatisationsanlage oder ein Gebäudeleitsystem. Durch die betriebstechnische Anlage werden insbesondere auch Raumklimagrössen wie Raumtemperatur, Luftfeuchtigkeit und Luftqualität beeinflusst. In der betriebstechnische Anlage ist eine Vielzahl sogenannter Feldgeräte wie Sensoren und Stellglieder durch elektrische Signale zu bedienen. In der Regel werden analoge Signale der Feldgeräte zur Übertragung und/oder zur Verarbeitung durch Analog-Digital-Wandler in digitale Signale umgesetzt.

Typischerweise ist ein analoges Signal leider auch von einer Störgrösse überlagert, welche durch elektrische und/oder magnetische Felder des Energieversorgungsnetzes oder durch am Energieversorgungsnetz angeschlossene Komponenten auf das analoge Nutzsignal moduliert werden. Das analoge Nutzsignal ist beispielsweise das einer gemessenen physikalischen Grösse entsprechende Signal eines Sensors; beispielsweise eines Temperatur- oder Feuchtesensors. Die besagte Störgrösse hat die Frequenz des Energieversorgungsnetzes und wird auch als Netzbrumm bezeichnet. Insbesondere bei analogen Signalen in einem Gebäude ist der Netzbrumm oft nicht vemachlässigbar.

Bei der Umsetzung eines analogen Signals in ein digitales Signal werden weit verbreitet Analog-Digital-Wandler eingesetzt, welche nach dem sogenannten Sigma-Delta-Verfahren arbeiten. Wenn nun beim Sigma-Delta-Verfahren die beim Abtasten eines analogen Signals eingesetzte Abtastrate und die Dezimationsrate geeignet gewählt werden, kann das Sigma-Delta-Verfahren bekannterweise auch als Filter für gewisse Frequenzen des analogen Signals wirken. Eine genügende Unterdrückung des Netzbrumms ist jedoch nur dann erreichbar, wenn der aus der Abtastrate und der Frequenz des Energieversorgungsnetzes gebildete Quotient konstant ist. In der Regel wird die Abtastrate von einem mit einem Quarz stabilisierten Oszillator abgeleitet.

Die Frequenz des Energieversorgungsnetzes beträgt in gewissen Regionen und Ländem 50 Hz in andern jedoch 60 Hz. Ausserdem kann die Frequenz je nach Qualität des Energieversorgungsnetzes von einem Nennwert abweichen. Im vorliegenden Fall wird mit einer Abweisung von +/- 4 % vom Nennwert gerechnet.

Ohne besondere Massnahmen ist bei einer Analog-Digital-Umsetzung eine genügende Unterdrückung des Netzbrumms nur entweder für 50 Hz - oder 60 Hz - Netze erreichbar was einem weltweit einsetzbaren Produkt entgegensteht.

Aus US 4,993,052 ist ein elektronisches Gerät bekannt, welches Netzfrequenzen von 50 Hz oder 60 Hz selbsttätig verarbeitet. Während einer Vollwelle der Netzfrequenz werden Impulse einer vorgegebenen Frequenz gezählt und diskriminiert. Abhängig vom Ergebnis dieser Diskriminierung wird ein der Netzfrequenz zugeordnetes Signal in einem Teilerverhältnis 50:1 oder dann 60:1 geteilt, so dass ein Taktsignal von 1 Hz generierbar ist, unabhängig davon ob die Netzfrequenz 50 Hz oder 60 Hz ist.

Der Erfindung liegt die Aufgabe zugrunde, ein Verfahren zur Generierung eines Abtasttakt-Signals für einen nach dem Sigma-Delta-Verfahren arbeitenden Analog-Digital-Wandler anzugeben, welches in allen Regionen den Netzbrumm genügend unterdrückt. Ausserdem soll eine Einrichtung geschaffen werden, mit der das Verfahren durchführbar ist.

Die genannte Aufgabe wird erfindungsgemäss durch die Merkmale der Ansprüche 1 und 4 gelöst. Vorteilhafte Ausgestaltungen der Erfindung ergeben sich aus den abhängigen Ansprüchen.

Nachfolgend werden Ausführungsbeispiele der Erfindung anhand der Zeichnung näher erläutert.

Es zeigen:
- Fig. 1: ein Blockschaltbild mit einem Analog-Digital-Wandler und einer Anordnung zur Generierung eines Abtasttakt-Signals,
- Fig. 2: eine Darstellung zur Funktionsweise der Anordnung, und

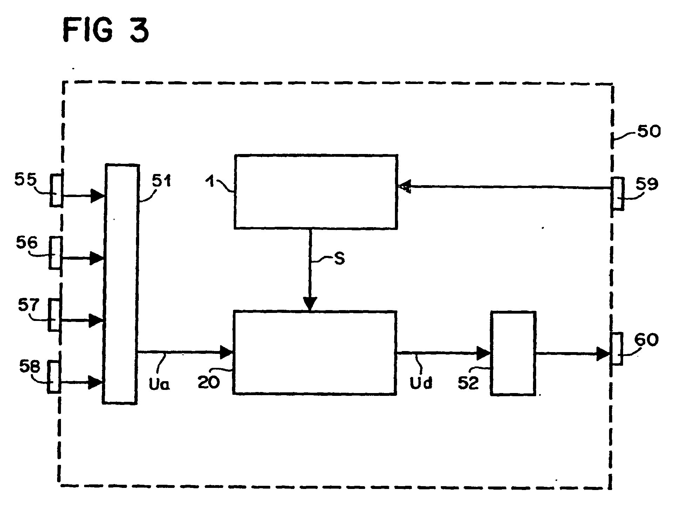

- Fig. 3: ein Blockschaltbild zur Anwendung der Anordnung.

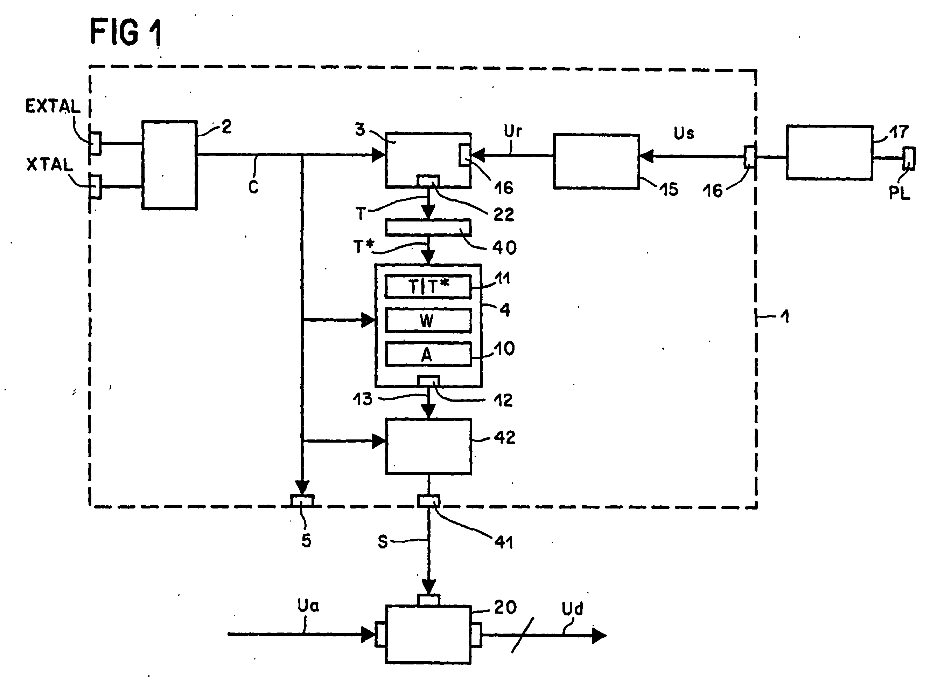

In der Fig. 1 ist mit 1 ein Taktgenerator bezeichnet, der einen Oszillator 2, einen Zähler 3 und eine Akkumulatoreinheit 4 aufweist. Der Oszillator 2 generiert ein Systemtakt-Signal C, das auf den Zähler 3 und die Akkumulatoreinheit 4 und mit Vorteil auch auf einen ersten Anschlusspunkt 5 des Taktgenerators 1 geführt ist.

Der Oszillator 2 ist vorzugsweise über einen extern angeordneten Quarz stabilisiert, der beispielhaft über einen zweiten Anschlusspunkt XTAL und einen dritten Anschlusspunkt EXTAL des Taktgenerators 1 mit dem Oszillator 2 verbindbar ist.

Die Akkumulatoreinheit 4 weist mit Vorteil ein Addierregister 10, ein weiteres Register 11 und einen Ausgang 12 für ein Ausgangssignal 13 auf.

Der Taktgenerator 1 weist vorteilhafterweise auch einen Signalwandler 15 auf, durch den eine an einem Eingang des Signalwandlers 15 liegende sinusförmige Wechselspannung Us in ein rechteckförmiges Signal Ur umgewandelt wird, das von einem Ausgang des Signalwandlers 15 auf einen Eingang 16 des Zählers 3 geführt ist und das die Periodendauer T der Wechselspannung Us aufweist. Der Signalwandler 15 ist beispielhaft eine Komparatorschaltung.

Die Wechselspannung Us wird dem Energieversorgungsnetz PL entnommen und vorteilhafterweise vor der Zuführung über einen vierten Anschlusspunkt 16 in einem Anpassungsglied 17 entstört und auf einen erforderlichen Spannungspegel gebracht.

Da die Frequenz der vom Energieversorgungsnetz PL gelieferten Wechselspannung je nach Region typischerweise 50 Hz oder 60 Hz beträgt, und ausserdem die Nennfrequenz in gewissen Toleranzgrenzen schwanken kann, wird hier die Frequenz des Energieversorgungsnetzes PL und damit natürlich auch die damit verbundene Periodendauer T grundsätzlich variabel angenommen.

Das Anpassungsglied 17 umfasst mit Vorteil ein Tiefpassfilter. Das Anpassungsglied 17 ist typischerweise nicht zusammen mit dem Taktgenerator 1 in einem Baustein integriert.

Erfindungsgemäss wird die gestellte Aufgabe durch ein Verfahren gelöst, in dem in einem ersten Verfahrensschritt die variable Periodendauer T des Energieversorgungsnetzes PL in Zeiteinheiten des Systemtakt-Signals C ermittelt und weiter in einem zweiten Verfahrensschritt ein Abtasttakt-Signal S durch Verteilen einer konstanten Anzahl K Impulse über die ermittelte Periodendauer T generiert wird, sodass die Frequenz des Abtasttakt-Signals S ein ganzzahliges Vielfaches der Frequenz des Energieversorgungsnetzes ist.

Wenn die Anzahl K gleich dem Wert der Dezimationsrate eines nach dem Sigma-Delta-Verfahren arbeitenden Analog-Digital-Wandlers 20 gewählt ist, und im Analog-Digital-Wandler 20 das Abtasttakt-Signal S zur Abtastung eines zugeführten Analogsignals Ua eingesetzt wird, kann der Netzbrumm des Analogsignal Ua bei der Abtastung optimal unterdrückt beziehungsweise ausgefiltert werden. Das vom Analog-Digital-Wandler 20 aus dem Analogsignal Ua generierte Digitalsignal Ud ist damit auch dann optimal vom Netzbrumm befreit, wenn die Frequenz des Energieversorgungsnetzes PL ändert. Die selbsttätige optimale Unterdrückung des Netzbrumms wird dabei unabhängig davon erreicht, ob der Taktgenerator 1 in Regionen mit unterschiedlicher Frequenz des Energieversorgungsnetzes PL eingesetzt wird, oder ob die Frequenz des Energieversorgungsnetzes PL aus andern Gründen schwankt.

Die erreichbare Genauigkeit, mit der die Periodendauer T des Energieversorgungsnetzes PL erfassbar ist, ist durch den Wert der Frequenz des Systemtakt-Signals C bestimmt. In der Regel ist das Systemtakt-Signal C auch zum Takten weiterer, im Zusammenhang mit der vorliegenden Erfindung nicht angesprochener Komponenten - wie beispielsweise Mikroprozessoren oder Multiplexer - einsetzbar, deren Anforderungen die erforderliche Frequenz des Systemtakt-Signals C mitbestimmen können. In einer beispielhaften Ausführung der Erfindung sei die Frequenz des Systemtakt-Signals C etwa 5 MHz.

In einer vorteilhaften Ausführung der Erfindung ermittelt der mit dem Systemtakt-Signal C getaktete Zähler 3, die Periodendauer T des Energieversorgungsnetzes PL in Zeiteinheiten des Systemtakt-Signals C. Die durch Zählen von in einer Periode des rechteckförmigen Signals Ur eintreffenden Pulsen des Systemtakt-Signals C ermittelte Periodendauer T, ist an einem Ausgang 22 des Zählers 3 verfügbar.

In der Akkumulatoreinheit 4 wird die ermittelte Periodendauer T im Register 11 abgespeichert und als Zählgrenze oder Maximalwert für das Addierregister 10 eingesetzt. Mit jedem Impuls des Systemtakt-Signals C wird der aktuelle Inhalt A des Addierregisters 10 um einen konstanten Wert W erhöht, wobei bei einem Überschreiten der Zählgrenze am Ausgang 12 ein Impuls des Ausgangssignals 13 generiert wird, und im Addierregister 10 nur ein Restwert abgespeichert wird. Der Restwert ist der Rest der ganzzahligen Division des Inhalts A des Addierregisters 10 durch die aktuelle Zählgrenze. Es wird also eine so genannte Modulo-Division durchgeführt; in Pseudocode dargestellt: A:= (A + W) modulo T. Damit sind am Ausgang 12 eine konstante dem Wert W gleichgesetzte Anzahl Impulse über eine mit der Periodendauer T gleichgesetzte Zeitspanne gleichmässig verteilt generierbar.

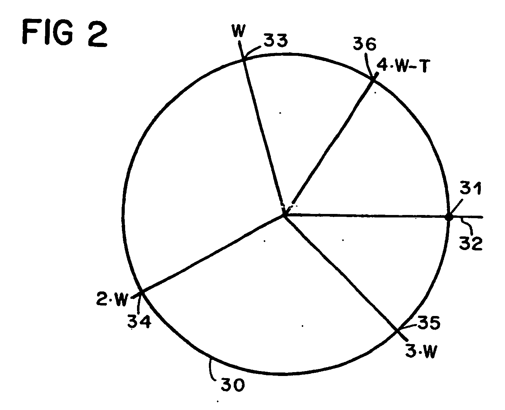

Das Prinzip der Wirkungsweise der Akkumulatoreinheit ist in der Fig. 2 veranschaulicht. Die aktuelle Periodendauer T ist durch den Umfang eines Kreises 30 dargestellt. Ein Schnittpunkt 31 des Kreises 30 mit einer Zentrumslinie 32 stellt sowohl den minimalen Inhalt A des Addierregisters 10 - nämlich null- wie auch den maximalen Inhalt A - nämlich die Zählgrenze - dar. Mit jedem Impuls des Systemtakt-Signals C wird zum aktuellen Inhalt A der konstanten Wert W dazugezählt. Beginnt man bei null, so beinhaltet das Addierregister 10 im gezeigten Beispiel nach dem ersten Impuls den mit einem Punkt 33 dargestellten Wert W, nach dem zweiten Impuls den mit einem Punkt 34 dargestellten doppelten Wert W und nach dem dritten Impuls den mit einem Punkt 35 dargestellten dreifachen Wert W. Nach dem vierten Impuls wird im Schnittpunkt 31 die Zählgrenze überschritten, wobei am Ausgang 12 der Akkumulatoreinheit 4 (Fig. 1) ein Impuls des Ausgangssignals 13 generiert und der Inhalt A des Addierregisters 10 auf den mit einem Punkt 36 dargestellten um die Periodendauer T verminderten vierfachen Wert W gesetzt wird. In diesem Modell ändert sich der Umfang des Kreises 30 entsprechend einer allfälligen Änderung der Frequenz des Energieversorgungsnetzes.

In einem konkreten Beispiel sei die Frequenz des Energieversorgungsnetzes 50 Hz und die Frequenz des Systemtakt-Signals 5 MHz. Der konstante Wert W sei 16'384 also 2 ¹⁴. Der Umfang des Kreises 30 entspricht damit einer Zahl 1 00'000. Der Inhalt A des Addierregisters 10 ist in der nachfolgenden Tabelle für acht Impulse des Systemtakt-Signals C ausgehend von null dargestellt:

| Impuls des Systemtakt-Signals | Inhalt A | Impuls am Ausgang 12 |
|---|---|---|
| 0 | 0 | nein |
| 1 | 16384 | nein |
| 2 | 32768 | nein |
| 3 | 49152 | nein |
| 4 | 65536 | nein |
| 5 | 81920 | nein |
| 6 | 98304 | nein |
| 7 | 14688 | ja |
| 8 | 31072 | nein |

Immer dann, wenn im Addierregister 10 die Zählgrenze überschritten wird, wird am Ausgang 12 der Akkumulatoreinheit 4 ein Impuls generiert. Damit werden im Beispiel 16'384 Impulse gleichmässig über die gemessene Periodendauer T des Energieversorgungsnetzes verteilt.

Bei der Ermittlung der Periodendauer T können Fehler auftreten, die beispielsweise durch Störungen der am vierten Anschlusspunkt 16 angelegten sinusförmigen Wechselspannung Us verursacht werden, und beispielhaft durch ein Tiefpassfilter korrigierbar sind. Zur Korrektur solche Fehler wird in einer vorteilhaften Ausführungsvariante der Erfindung ein digitales Filter 40 zwischen den Zähler 3 und die Akkumulatoreinheit 4 geschaltet. Die vom Zähler 3 gezählte Periodendauer T wird durch das digitale Filter 40 in eine gefilterte Periodendauer T* umgesetzt. Die im Register 11 abgespeicherte Zählgrenze ist also bei der Verwendung des Filters 40 die gefilterte Periodendauer T*.

Das an einem fünften Anschlusspunkt 41 verfügbare Abtasttakt-Signal S wird im Taktgenerator 1 so aufbereitet, dass der Netzbrumm des im Analog-Digital-Wandler 20 abgetasteten Analogsignal Ua bei der Abtastung optimal unterdrückt wird. Die erwünschte optimale Unterdrückung wird erreicht, wenn die Rate des Abtasttakt-Signals S gleich dem aus der Frequenz des Energieversorgungsnetzes und der Dezimationsrate des eingesetzten Analog-Digital-Wandlers 20 gebildeten Produkts ist.

Für Energieversorgungsnetze mit einer Frequenz von 50Hz und einer Dezimationsrate von 2¹³= 8192 wird also ein Abtasttakt-Signal S gefordert, welches pro Impuls des Energieversorgungsnetzes konstant 8192 Impulse aufweist, welche gleichmässig über eine Periode des Energieversorgungsnetzes aufgeteilt sind.

Der nach dem Sigma-Delta-Verfahren arbeitende Analog-Digital-Wandler 20 verlangt typischerweise ein symmetrisches Abtasttakt-Signal S, das heisst Impuls und Pause sollten gleich lang sein.

Das Abtasttakt-Signal S ist genügend symmetrisch generierbar, wenn es am Ausgang einer mit Vorteil durch das Systemtakt-Signal C getakteten Frequenzteilerstufe 42 entnommen wird, deren Eingang mit dem Ausgangssignal 13 der Akkumulatoreinheit 4 gespeist ist. Eine durch die Frequenzteilerstufe 42 vorgenommene Erniedrigung der Frequenz ist in der Akkumulatoreinheit 4 durch eine entsprechende Vergrösserung des konstanten Wertes W auszugleichen.

Mit Vorteil halbiert die Frequenzteilerstufe 42 die Frequenz des durch die Akkumulatoreinheit 4 gelieferten Ausgangssignals 13, was in der Akkumulatoreinheit 4 kompensiert wird, wenn der konstante Wert W auf die doppelte Dezimationsrate des Analog-Digital-Wandiers 20 festgelegt wird.

In einer Ausführungsvariante ohne die Frequenzteilerstufe 42 wird in der Akkumulatoreinheit 4 der konstante Wert W auf die Dezimationsrate des Analog-Digital-Wandlers 20 gesetzt.

Ein konstantes Verhältnis zwischen der Rate des Abtasttakt-Signals S und der Frequenz des Energieversorgungsnetzes PL liesse sich auch durch eine sogenannte Phase-Locked-Loop (PLL) erreichen. Allerdings ergeben sich bei einer Implementierung der klassische PLL Schaltung als integrierte Schaltung Probleme, wenn die beiden aufeinander abzustimmenden Frequenzen, wie im vorliegenden Fall derart weit auseinander liegen und eine der beiden Frequenzen, wie hier die Netzfrequenz, relativ nieder ist.

Im Gegensatz zu einer klassischen PLL, lässt sich eine digitale Schaltung gemäss der vorliegenden Erfindung zusammen mit dem Analog-Digital-Wandler 20 und bei Bedarf mit weiteren Schaltungseinheiten problemlos auch in einem sogenannter Application-Specific Integrated Circuit (ASIC) implementieren.

In der Fig. 5 sind einige Teilschaltungen eines ASIC 50 dargestellt. Der ASIC 50 umfasst den Taktgenerator 1, den Analog-Digital-Wandler 20 und ausserdem wenigstens einen Multiplexer 51 und eine Kommunikationsschnittstelle 52. Über den Multiplexer 51 ist der Analog-Digital-Wandler 20 eingangsseitig an Klemmen 55, 56, 57 oder 58 schaltbar, welche ihrerseits mit unterschiedlichen Feldgeräten verbindbar sind. Das anliegende Analogsignal Ua wird durch das vom Taktgenerator 1 generierte Abtasttakt-Signal S gelesen. Über eine weitere Klemme 59 ist der Taktgenerator 1 mit einer Wechselspannung des Energieversorgungsnetzes verbindbar. Ausgangsseitig ist der Analog-Digital-Wandler 20 über die Kommunikationsschnittstelle 52 beispielhaft mit einem an einem Port 60 angeschlossenen Prozessor verbindbar.

## Patentansprüche

1. Verfahren zur Generierung eines Abtasttakt-Signals (S) zur Abtastung eines Analogsignals (Ua) für einen nach dem Sigma-Delta-Verfahren arbeitenden Analog-Digital-Wandler (20), mit einem Verfahrensschritt zum
- Ermitteln einer variablen Periodendauer (T; T*) des Energieversorgungsnetzes (PL) in Zeiteinheiten eines Systemtakt-Signals (C), **gekennzeichnet durch** einen weiteren Verfahrensschritt zum
- Generieren des Abtasttakt-Signals (S) **durch** Verteilen einer konstanten Anzahl K Impulse über die ermittelte Periodendauer (T; T*), sodass die Frequenz des Abtasttakt-Signals (S) ein ganzzahliges Vielfaches der Frequenz des Energieversorgungsnetzes (PL) ist.

2. Verfahren nach Anspruch 1, **dadurch gekennzeichnet, dass** die Anzahl K gleich dem Wert der Dezimationsrate des Analog-Digital-Wandlers (20) ist.

3. Verfahren nach Anspruch 1 oder 2, **dadurch gekennzeichnet, dass** das Verteilen der konstanten Anzahl K Impulse über die ermittelte Periodendauer (T; T*) mittels Modulo-Division durchgeführt wird.

4. Einrichtung zur Durchführung eines Verfahrens zur Generierung eines Abtasttakt-Signals (S) für einen nach dem Sigma-Delta-Verfahren arbeitenden Analog-Digital-Wandler (20), nach einem der Ansprüche 1, 2 oder 3, **gekennzeichnet durch**
- einen mit einem Systemtakt-Signal (C) getakteten Zähler (3), der einen weiteren Eingang (16) aufweist, auf den ein von einem Energieversorgungsnetz (PL) abgeleitetes Signal (Ur) geführt ist, so dass vom Zähler (3) die Periodendauer (T) des Energieversorgungsnetzes (PL) in Zeiteinheiten des Systemtakt-Signals (C) ermittelt wird, und,
- eine mit dem Systemtakt-Signal (C) getaktete, ein Addierregister (10) und einen Ausgang (12) für das Abtasttaktsignal (13; S) aufweisende Akkumulatoreinheit (4), der die ermittelte Periodendauer (T; T*) als Zählgrenze zuweisbar ist, und in der der aktuelle Wert (A) des Addierregisters (10) mit jedem Impuls des Systemtakt Signals (C) um einen konstanten Wert W erhöht wird, wobei jeweils dann, wenn im Addierregister (10) die Zählgrenze überschritten wird, am Ausgang (12) ein Impuls generiert wird, so dass das Abtasttaktsignal (13; S), verteilt über die ermittelte Periodendauer (T), eine konstante, dem Wert W gleichgesetzte Anzahl Impulse aufweist.

5. Einrichtung nach Anspruch 4, **gekennzeichnet durch** ein zwischen den Zähler (3) und die Akkumulatoreinheit (4) geschaltetes digitales Filter (40), **durch** welches die vom Zähler (3) gezählte Periodendauer (T) gefiltert wird.

6. Einrichtung nach einem der Ansprüche 4 oder 5, **dadurch gekennzeichnet, dass** der Wert W gleich dem Wert der Dezimationsrate des Analog-Digital-Wandlers (20) ist.

7. Einrichtung nach einem der Ansprüche 4 oder 5, **dadurch gekennzeichnet, dass** der Wert W gleich dem doppelten Wert der Dezimationsrate des Analog-Digital-Wandlers (20) ist.

8. Einrichtung nach Anspruch 7, **gekennzeichnet durch** einen der Akkumulatoreinheit (4) nachgeschalteten Frequenzteiler (42), **durch** den die Frequenz des Ausgangssignals (13) der Akkumulatoreinheit (4) halbiert wird.

## Claims

1. Method for generation of a sampling clock signal (S) for sampling an analogue signal (Ua) for an analogue/digital converter (20) which operates using the sigma-delta method, having a method step for
- determination of a variable period duration (T; T*) of the power supply network (PL) in time units of a system clock signal (C),
**characterized by** a further method step for
- generation of the sampling clock signal (S) by distribution of a constant number K of pulses over the determined period duration (T; T*), such that the frequency of the sampling clock signal (S) is an integer multiple of the frequency of the power supply network (PL).

2. Method according to Claim 1, **characterized in that** the number K is equal to the value of the decimation rate of the analogue/digital converter (20).

3. Method according to Claim 1 or 2, **characterized in that** the distribution of the constant number of K pulses over the determined period duration (T; T*) is carried out by means of Modulo division.

4. Device for carrying out a method for generation of a sampling clock signal (S) for an analogue/digital converter (20) which operates using the sigma-delta method, according to one of Claims 1, 2 or 3, **characterized by**
- a counter (3) which is clocked by a system clock signal (C) and has a further input (16) to which a signal (Ur) which is derived from a power supply network (PL) is passed, such that the counter (3) determines the period duration (T) of the power supply network (PL) in time units of the system clock signal (C), and,
- an accumulator unit (4) which is clocked with the system clock signal (C), and has an adder register (10) and an output (12) for the sampling clock signal (13; S), and to which the determined period duration (T; T*) can be assigned as a numerical limit, and in which the current value (A) of the adder register (10) is increased by a constant value W with each pulse of the system clock signal (C), with a pulse being generated at the output (12) whenever the numerical limit in the adder register (10) is exceeded, such that the sampling clock signal (13; S) has a constant number of pulses, equal to the value W, distributed over the determined period duration (T).

5. Device according to Claim 4, **characterized by** a digital filter (40) which is connected between the counter (3) and the accumulator unit (4) and is used to filter the period duration (T) counted by the counter (3).

6. Device according to one of Claims 4 or 5, **characterized in that** the value W is equal to the value of the decimation rate of the analogue/digital converter (20).

7. Device according to one of Claims 4 or 5, **characterized in that** the value W is equal to twice the value of the decimation rate of the analogue/digital converter (20).

8. Device according to Claim 7, **characterized by** a frequency divider (42) which is connected downstream from the accumulator unit (4) and halves the frequency of the output signal (13) from the accumulator unit (4).

## Revendications

1. Procédé générateur d'un signal d'horloge d'échantillonnage (S) pour échantillonner un signal analogique (Ua) pour un convertisseur analogique numérique (20) opérant selon le procédé sigma delta, comprenant une étape pour
- déterminer une durée de période (T; T*) variable du réseau d'alimentation en énergie (PL) en unités de temps d'un signal d'horloge du système (C), **caractérisé par** une autre étape pour
- générer le signal d'horloge d'échantillonnage (S) par répartition d'un nombre constant K d'impulsions sur la durée de période (T; T*) déterminé de sorte que la fréquence du signal d'horloge d'échantillonnage (S) est un multiple entier de la fréquence du réseau d'alimentation en énergie (PL).

2. Procédé selon la revendication 1, **caractérisé en ce que** le nombre K est égal à la valeur du taux de décimation du convertisseur analogique numérique (20).

3. Procédé selon la revendication 1 ou 2, **caractérisé en ce que** la répartition du nombre constant K d'impulsions sur la durée de période (T; T*) déterminée est effectuée par division modulo.

4. Dispositif de mise en oeuvre d'un procédé générateur d'un signal d'horloge d'échantillonnage (S) pour un convertisseur analogique numérique (20) opérant selon le procédé sigma delta selon l'une des revendications 1, 2 ou 3, **caractérisé par**
- un compteur (3) synchronisé avec un signal d'horloge de système (C), lequel comporte une autre entrée (16) à laquelle est amené un signal (Ur) dérivé d'un réseau d'alimentation en énergie (PL) de sorte que la durée de période (T) du réseau d'alimentation en énergie (PL) est déterminée en unités de temps du signal d'horloge du système (C) par le compteur (3) et
- une unité d'accumulation (4) synchronisée avec le signal d'horloge du système (C), comportant un registre additionneur (10) et une sortie (12) pour le signal d'horloge d'échantillonnage (13; S), à laquelle unité la durée de période (T; T*) déterminée est affectable en tant que limite de comptage et dans laquelle la valeur actuelle (A) du registre additionneur (10) est augmentée d'une valeur constante W à chaque impulsion du signal d'horloge du système (C), une impulsion étant générée à la sortie (12) chaque fois que la limite de comptage est dépassée dans le registre additionneur (10), de sorte que le signal d'horloge d'échantillonnage (13; S) présente, de manière répartie sur la durée de période (T) déterminée, un nombre d'impulsions constant assimilé à la valeur W.

5. Dispositif selon la revendication 4, **caractérisé par** un filtre numérique (40) monté entre le compteur (3) et l'unité d'accumulation (4), par lequel est filtrée la durée de période (T) comptée par le compteur (3).

6. Dispositif selon l'une des revendications 4 ou 5, **caractérisé en ce que** la valeur W est égale à la valeur du taux de décimation du convertisseur analogique numérique (20).

7. Dispositif selon l'une des revendications 4 ou 5, **caractérisé en ce que** la valeur W est égale au double de la valeur du taux de décimation du convertisseur analogique numérique (20).

8. Dispositif selon la revendication 7, **caractérisé par** un diviseur de fréquence (42) monté en aval de l'unité d'accumulation (4), par lequel la fréquence du signal de sortie (13) de l'unité d'accumulation (4) est divisée par deux.
